# EUROPEAN PATENT APPLICATION

(11) **EP 1 748 506 A2**
(43) Date of publication of application: **31.01.2007**
(21) Application number: 06014023.3
(22) Date of filing: 06.07.2006
(51) Int. Cl.: H01L 51/50

(54) **Method of making a display device, a display device made thereby and a thin film transistor substrate made thereby**

(30) Priority: 30.07.2005 KR 20050069956
(71) Applicant: Samsung Electronics Co., Ltd., Yeongtong-gu Suwon-city, Gyeonggi-do 442-742 (KR)
(72) Inventor: Oh, Joon-hak, Yongin-si Gyeonggi-do (KR)
(74) Representative: Weitzel, Wolfgang

(57) **Abstract**

A method for making a display device, a display device made thereby, and a thin film transistor substrate made thereby are provided. In one example, the method includes providing a template having at least one pore and generating one-dimensional nano material in the pore by supplying an organic substance in gas phase. Advantageously, wall thickness and the formation of multiple layers are easily regulated.

## Description

### CROSS-REFERENCE TO RELATED APPLICATIONS

This application claims priority from Korean Patent Application No. 2005-0069956, filed on July 30, 2005, in the Korean Intellectual Property Office, the disclosure of which is incorporated herein by reference.

### BACKGROUND OF INVENTION

### Field of Invention

The present invention relates to a preparation method of a display device, a display device produced thereby, and a thin film transistor substrate produced thereby, and more particularly, to a preparation method of a display device using gas phase organic substances, a display device produced thereby, and a thin film transistor substrate.

### Description of the Related Art

Organic one-dimensional nano materials, such as nanotubes and nanowires, have recently drawn our attention because of their potential application to the production of a nano size transistor, a sensor and a molecular wire and a field emission display.

Up to now, organic one-dimensional nano materials have been produced by solution polymerization using inorganic or organic templates. However, the conventional solution polymerization using inorganic or organic templates has problems in regulating the thickness of the wall of organic one-dimensional nano material produced because of capillary condensation and interfacial tension between a monomer and a template. In particular, during the production of multi-layer organic one-dimensional nano material, the regulation of the thickness of the wall is more difficult because of pore clogging of a template resulting from serial injection of liquid monomers.

### SUMMARY OF THE INVENTION

Accordingly, it is an aspect of the present invention to provide a preparation method of display devices facilitating the regulation of wall thickness and the formation of multiple layers.

It is another aspect of the present invention to provide a display device produced by the preparation method of the present invention facilitating the regulation of wall thickness and the formation of multiple layers.

It is a further aspect of the present invention to provide a thin film transistor substrate produced by the preparation method of the invention facilitating the regulation of wall thickness and the formation of multiple layers.

Additional aspects and/or advantages of the present invention will be set forth in part in the description which follows and, in part, will be obvious from the description, or may be learned by practice of the present invention.

The foregoing and/or other aspects of the present invention can be achieved by providing a method for preparing a display device, the method comprising: providing a template having at least one pore; and generating a one-dimensional nano material in the pore by supplying an organic substance in gas phase.

According to an exemplary embodiment of the present invention, the organic substance is supplied under a vacuum condition.

According to an exemplary embodiment of the present invention, the organic substance is supplied by evaporating the organic substance in liquid phase.

According to an exemplary embodiment of the present invention, the method further comprises supplying an additional organic substance which is different from the organic substance.

According to an exemplary embodiment of the present invention, the organic substance is selected from the group consisting of methylmethacrylate, styrene, divinylbenzene, vinylpropylene, pyrrole, aniline, thiophene, pentacene, rubrene, and mixtures thereof.

According to an exemplary embodiment of the present invention, the organic substance is a low molecular substance, and the one-dimensional nano material is an assembly of the low molecular substance.

According to an exemplary embodiment of the present invention, the organic substance comprises one of pentacene and rubrene.

According to an exemplary embodiment of the present invention, the organic substance is a monomer, and further comprising polymerizing the monomer in the pore.

According to an exemplary embodiment of the present invention, the polymerizing is performed at between about 500 and about 200□..

According to an exemplary embodiment of the present invention, the method further comprises supplying an initiator in the pore before the injection of the organic substance.

According to an exemplary embodiment of the present invention, the initiator is a radical polymerization initiator.

According to an exemplary embodiment of the present invention, the organic substance is selected from the group consisting of methylmethacrylate, styrene, divinylbenzene, vinylphenol, and mixtures thereof.

According to an exemplary embodiment of the present invention, the initiator comprises at least one of 2,2'-azobisisobutyronitrile (AIBN) and benzoyl peroxide (BPO).

According to an exemplary embodiment of the present invention, the initiator is an oxidizing agent.

According to an exemplary embodiment of the present invention, the organic substance is selected from the group consisting of pyrrole, aniline, thiophene, and mixtures thereof.

According to an exemplary embodiment of the present invention, the initiator comprises FeCl₃.

According to an exemplary embodiment of the present invention, the template is composed of anodic aluminum oxide membrane.

According to an exemplary embodiment of the present invention, the method further comprises separating the one-dimensional nano material from the template.

According to an exemplary embodiment of the present invention, the template is composed of an anodic aluminum oxide membrane, and further wherein the one-dimensional nano material is separated from the template by etching.

According to an exemplary embodiment of the present invention, at least one of sodium hydroxide and chloric acid is used for etching of the template.

According to an exemplary embodiment of the present invention, the one-dimensional nano material generated in the pore is composed of a core and a tube type shell covering the core, and further comprising removing both ends of the shell.

According to an exemplary embodiment of the present invention, the core is an organic semiconductor and the shell is an organic insulator.

According to an exemplary embodiment of the present invention, the removing is performed by supplying a solvent that selectively dissolves the shell at both ends.

According to an exemplary embodiment of the present invention, the solvent comprises at least one of acetone and methylenechloride.

The foregoing and/or other aspects of the present invention are also achieved by providing a method for preparing a display device, the method comprising: providing a template having at least one pore under about 200 nm in diameter; supplying an initiator in the pore; generating a one-dimensional nano material in the pore by supplying and polymerizing a monomer in gas phase; and separating the generated one-dimensional nano material from the template.

According to an exemplary embodiment of the present invention, the monomer is supplied by evaporating the monomer in liquid phase.

The foregoing and/or other aspects of the present invention are also achieved by providing a display device, comprising: a tube type shell under about 200 nm in diameter; and a core formed in the shell.

According to an exemplary embodiment of the present invention, at least one of the shell and the core is a conducting polymer.

According to an exemplary embodiment of the present invention, the conducting polymer is selected from the group consisting of polypyrrole, polyaniline, and polythiophene.

According to an exemplary embodiment of the present invention, at least one of the shell and the core is an organic semiconductor.

According to an exemplary embodiment of the present invention, the organic semiconductor is selected from the group consisting of polypyrrole, polyaniline, polythiophene, pentacene, and rubrene.

According to an exemplary embodiment of the present invention, one of the shell and the core is an organic insulator.

According to an exemplary embodiment of the present invention, the organic insulator is selected from the group consisting of polymethylmethacrylate, polystyrene, polydivinylbenzene, and polyvinylphenol.

According to an exemplary embodiment of the present invention, the shell is an organic insulator and the core is an organic semiconductor.

According to an exemplary embodiment of the present invention, the shell is eliminated at both ends to expose the core.

According to an exemplary embodiment of the present invention, the core is a solid type.

According to an exemplary embodiment of the present invention, the display device further comprises an additional shell formed between the core and the shell.

According to an exemplary embodiment of the present invention, the core is an organic semiconductor, the shell is an organic insulator, and the additional shell is a conducting polymer.

According to an exemplary embodiment of the present invention, the core is a solid type.

The foregoing and/or other aspects of the present invention are also achieved by providing a display device, comprising: an organic semiconductor core; an organic insulator shell covering the organic semiconductor core; and a conducting polymer shell under about 200 nm in diameter covering the organic insulator shell.

According to an exemplary embodiment of the present invention, the organic semiconductor core is selected from the group consisting of polypyrrole, polyaniline, polythiophene, pentacene, and rubrene.

According to an exemplary embodiment of the present invention, the organic insulator shell is comprised of material selected from the group consisting of polymethylmethacrylate, polystyrene, polydivinylbenzene, and polyvinylphenol.

According to an exemplary embodiment of the present invention, the conducting polymer shell is comprised of material selected from the group consisting of polypyrrole, polyaniline, and polythiophene.

The foregoing and/or other aspects of the present invention are also achieved by providing a thin film transistor substrate, comprising: a one dimensional nano material comprising a tube type shell made of organic insulator and a core made of organic semiconductor formed in the shell, wherein the one-dimensional nano material is under about 200 nm in diameter and the core is exposed at both ends; a gate electrode over the core covered by the shell; a source electrode connected to one end of the core; and a drain electrode connected to the other end of the core.

According to an exemplary embodiment of the present invention, the gate electrode contacts the shell.

According to an exemplary embodiment of the present invention, the core is a solid type.

According to an exemplary embodiment of the present invention, the one-dimensional nano material further comprises an additional shell composed of a conducting polymer which is a tube type to accommodate the shell.

According to an exemplary embodiment of the present invention, the gate electrode contacts the additional shell.

According to an exemplary embodiment of the present invention, the additional shell is comprised of a material selected from the group consisting of polypyrrole, polyaniline, and polythiophene.

According to an exemplary embodiment of the present invention, the core is comprised of a material selected from the group consisting of polypyrrole, polyaniline, polythiophene, pentacene, and rubrene.

According to an exemplary embodiment of the present invention, the shell is comprised of material selected from the group consisting of polymethylmethacrylate, polystyrene, polydivinylbenzene, and polyvinylphenol.

The scope of the invention is defined by the claims, which are incorporated into this section by reference. A more complete understanding of embodiments of the present invention will be afforded to those skilled in the art, as well as a realization of additional advantages thereof, by a consideration of the following detailed description of one or more embodiments. Reference will be made to the appended sheets of drawings that will first be described briefly.

### BRIEF DESCRIPTION OF THE DRAWINGS

The above and/or other aspects and advantages of the prevent invention will become apparent and more readily appreciated from the following description of the embodiments, taken in conjunction with the accompanying drawings, in which:
FIG. 1 and FIG. 2 are schematic diagrams showing the preparation method for one-dimensional nano materials in accordance with an embodiment of the present invention;
FIG. 3a through FIG. 3f are perspective views of one-dimensional nano materials prepared in Examples 1 through 6 of the present invention;
FIG. 4a and FIG. 4b are flow charts showing the preparation method for one-dimensional nano materials of Examples 2 and 3 of the present invention;
FIG. 5a and FIG. 5b are flow charts showing the preparation method for one-dimensional nano material of Example 4 of the present invention;
FIG. 6 is a flow chart showing the preparation method for one-dimensional nano material of Example 5 of the present invention;
FIG. 7a through FIG. 7c are TEM photographs of one-dimensional nano materials prepared by a method of the present invention; and
FIG. 8 through FIG. 10 are sectional drawings of thin film transistor substrates of Examples 7 through 9 of the present invention.

Embodiments of the present invention and their advantages are best understood by referring to the detailed description that follows. It should be appreciated that like reference numerals are used to identify like elements illustrated in one or more of the figures. It should also be appreciated that the figures may not be necessarily drawn to scale.

### DETAILED DESCRIPTION OF THE INVENTION

Reference will now be made in detail to the embodiments of the present invention, examples of which are illustrated in the accompanying drawings, wherein like reference numerals refer to like elements throughout. The embodiments are described below so as to explain the present invention by referring to the figures.

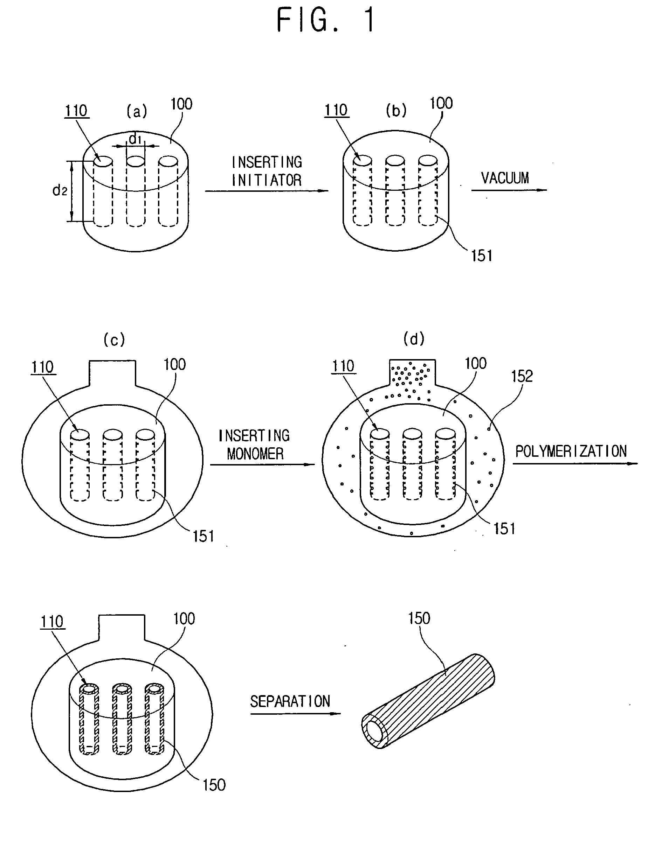

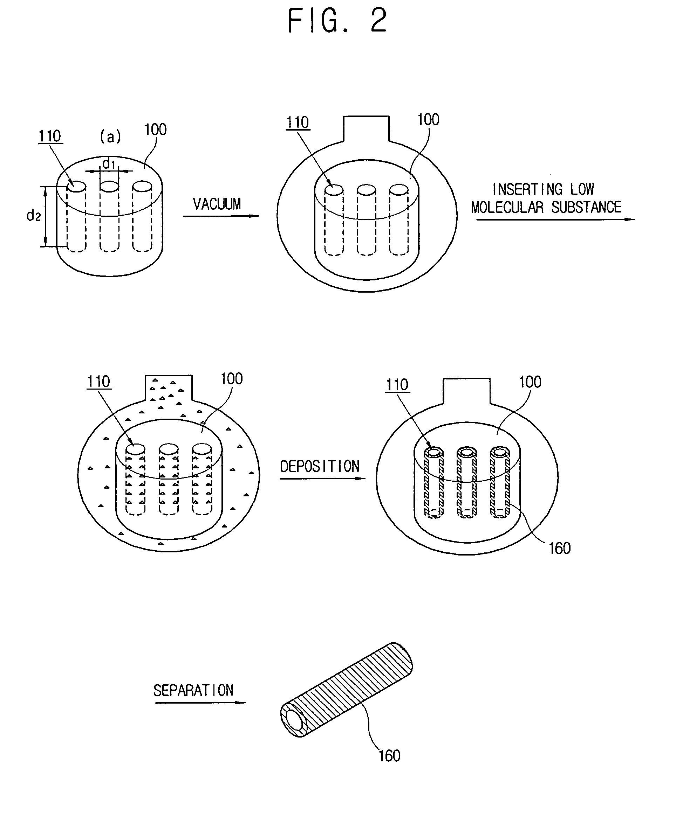

FIG. 1 and FIG. 2 are schematic diagrams showing the preparation method for one-dimensional nano materials of the present invention. The preparation method for one-dimensional nano materials of the invention includes both methods for producing high molecular and low molecular one-dimensional nano materials.

FIG. 1 shows the way to prepare a high molecular one-dimensional nano material by vapor polymerization.

First, a template (100) having a plurality of pores (110) is prepared as shown in (a). In one example, the pores (110) are less than 200 nm in diameter (d1) and may be less than 100 nm in diameter in another example. The template (100) is not limited to a specific template, but is preferably an anodic aluminum oxide membrane which is scores µm thick (d2).

Then, initiator (151) is supplied in the pores (110), as shown in (b). Radical polymerization or redox polymerization is started by the initiator (151). For radical polymerization, AIBN (2,2'-azobisisobutyronitrile) or BPO (benzoyl peroxide) is used as initiator (151) but is not limited thereto. For redox polymerization, FeCl₃ or hydrogen peroxide is used as initiator (151) but is not limited thereto.

The initiator (151), may be in gas phase or dissolved in a solvent.

Then, vacuum is applied as shown in (c), for which a template (100) is put in a vacuum chamber or in a vacuum glass vessel. A vacuum condition favors the evaporation of monomers (152). The level of vacuum may be 10⁻² torr or less in one example.

As shown in (d), gas phase monomers (152) are supplied in the pores (110). If the monomers (152) are in liquid phase or in solid phase at room temperature, they are vaporized under vacuum and by heating prior to application. The monomers (152) can be one of methylmethacrylate, styrene, divinylbenzene, vinylphenol, pyrrole, aniline, and thiophene, in one example, but is not limited thereto. For the initiator (151) inducing radical polymerization, the monomers can be one of methylmethacrylate, styrene, divinylbenzene, and vinylphenol, in one example. For the initiator (151) inducing redox polymerization, the monomers can be one of pyrrole, aniline, and thiophene, in one example.

Then, polymerization of monomers (152) is performed to produce a high molecular one-dimensional nano material (150). During the polymerization, the template (100) is heated at between about 50 - 200□ depending on the monomers (152) used. The one-dimensional nano material (150) is determined according to monomers (152) as polymethylmethacrylate, polystyrene, polydivinylbenzene, polyvinylphenol, polypyrrole, polyaniline, or polythiophene.

Among those compounds, polymethylmethacrylate, polystyrene, polydivinylbenzene, and polyvinylphenol are organic insulators, and polypyrrole, polyaniline, and polythiophene are either organic semiconductor or conducting polymer according to the degree of doping.

Redox polymerization of pyrrole, aniline, and thiophene may be initiated by using FeCl₃ as an initiator. Using FeCl₃ over a certain amount can make the nano material (150) a conduction polymer because the chloride in FeCl₃ acts as a dopant. On the other hand, using FeCl₃ below a certain amount makes the nano material (150) an organic semiconductor lacking certain conductivity.

It was also reported that a conductive high molecular nanotube would be turned from a conductor into an insulator via a semiconductor with the decrease of its diameter, which appears to be related to the changes of effective conjugation length. Thus, based on the characteristic, a conducting polymer and an organic semiconductor can be produced.

The one-dimensional nano-material (150) shown in FIG. 1 is a tube type, but can be prepared as a solid type by increasing the amount of monomers (152) supplied. The thickness of the one-dimensional nano material (150) corresponds to the diameter of a pore (110).

Then, the one-dimensional nano material (150) is separated from the template (100) in one embodiment. If a template (100) is anodic aluminum oxide membrane, the template (100) is eliminated by etching with HCl or NaOH to separate the one-dimensional nano material (150) from the template (100). The template (100) having the one-dimensional nano material (150) in the pores (110) may be used without separation in another embodiment.

The preparation method for the high molecular one-dimensional nano material using vapor deposition is described in more detail in the following experimental examples. In the experimental examples hereinafter, a polypyrrole nano tube is produced.

Aluminum membrane template of about 60 µm in thickness having pores 100 nm in diameter is soaked in 0.21 M of FeCl₃ solution, and then taken out of solution to evaporate the water. To prevent clogging and interconnection of polypyrrole nano tubes during its production process, the remaining FeCl₃ on the upper and the lower sides of the template is eliminated by using sandpaper in one example.

Then, the template is transferred to a 100 mL reaction vessel equipped with sealing apparatus and monomer injection pipe. The inside of the reaction vessel is depressurized to under 10⁻² torr at room temperature, to which 0.1 mL - 0.3 mL of pyrrole monomer is injected by using a pipette in one example. The monomer is evaporated at room temperature under reduced pressure until the vessel pressure reaches saturated vapor pressure. However, it is required to heat the monomer at 700 to evaporate all of the monomer.

The evaporated pyrrole is polymerized to form a polypyrrole nano tube in a pore of the template, and the color of the template is changed from white to black. About 12 hours later, the temperature is lowered and the vacuum condition is removed. Then, the template containing the polypyrrole nano tube is eliminated by etching in 3 M NaOH solution in one example. The salt of the template is dissolved in the solution and polypyrrole nano tube is precipitated. The precipitated nano tube is vacuum dried at room temperature to be collected.

FIG. 2 shows a preparation method for a low molecular one-dimensional nano material by vapor deposition.

First, a template (100) having a plurality of pores (110) is prepared as shown in (a). The pores (110) are less than 200 nm in diameter (d1) in one example and may be less than 100 nm in diameter in another example. The template (100) is not limited to a specific type or material, but an anodic aluminum oxide membrane which is scores µm thick (d2) is preferred.

Then, a vacuum condition is applied as shown in (b), for which a template (100) is put in a vacuum chamber or in a vacuum glass vessel. The vacuum condition favors the evaporation of low molecular substances (161). The level of vacuum may be 10⁻² torr or less in one example.

As shown in (c), gas phase low molecular substances (161) are supplied in the pores (110). If the low molecular substances (152) are in liquid phase or in solid phase at room temperature, they need to be vaporized under vacuum and by heating. The low molecular substances (161) may be one of pentacene and rubrene, in one example but are not limited thereto.

Then, as shown in (d), low molecular substances (161) are deposited in the pores (110), resulting in a low molecular one-dimensional nano material (160). A template can be heated according to the low molecular substances (161). The one-dimensional nano material (160) can be an organic semiconductor such as pentacene or rubrene according to the low molecular substances (161).

The one-dimensional nano material (160) of this example is a tube type, but the material can be prepared as a solid type by increasing the amount of low molecular substances (161). The thickness of the one-dimensional nano material corresponds to the diameter of a pore (110).

Then, the one-dimensional nano material (160) is separated from the template (100). If a template (100) is comprised of an anodic aluminum oxide membrane, in one example, the template (100) is eliminated by etching with HCl or NaOH, in one example, to separate the one-dimensional nano material (160) from the template (100). The template (100) having the one-dimensional nano material (160) in the pores (110) may be used without separation in another example.

The preparation method for one-dimensional nano materials using vapor polymerization or vapor deposition explained hereinbefore has at least the following advantages: first, a solvent is not required to produce a high molecular one-dimensional nano material, unlike conventional liquid phase polymerization; second, the thickness of one-dimensional nano material is easily adjusted; and third, easy regulation of thickness of the material facilitates the production of multiple one-dimensional nano materials having soft and even surfaces and interfaces.

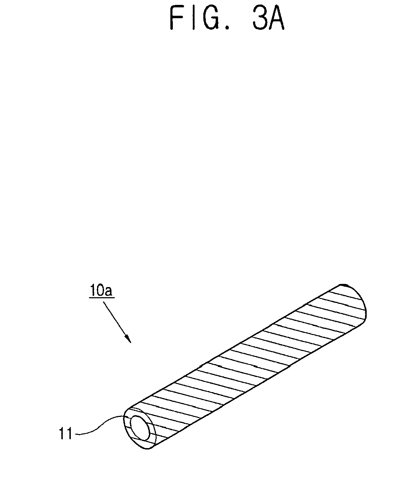

FIG. 3A - FIG. 3F are perspective views of one-dimensional nano materials prepared in Examples 1 - 6, respectively, of the present invention.

The one-dimensional nano material (10a) of Example 1 shown in FIG. 3A is formed by a monolayer of tube type core (11). The core (11) can be one of organic semiconductor, organic insulator, or conducting polymer prepared by vapor polymerization, and is an organic semiconductor prepared by vapor deposition.

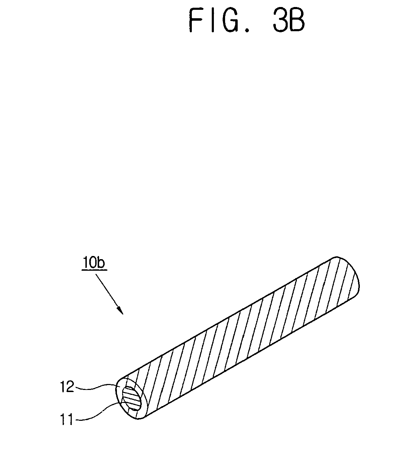

The one-dimensional nano material (10b) embodied in Example 2 shown in FIG. 3B has a double layer structure, in which a solid type core (11) is covered by a shell (12). The core (11) is an organic semiconductor prepared by vapor polymerization or vapor deposition, and the shell (12) is an organic insulator prepared by vapor polymerization.

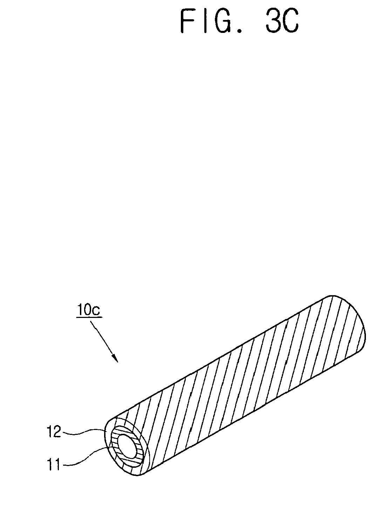

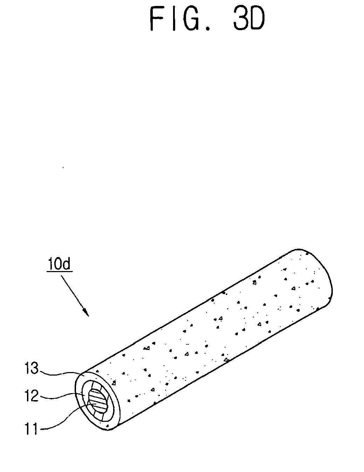

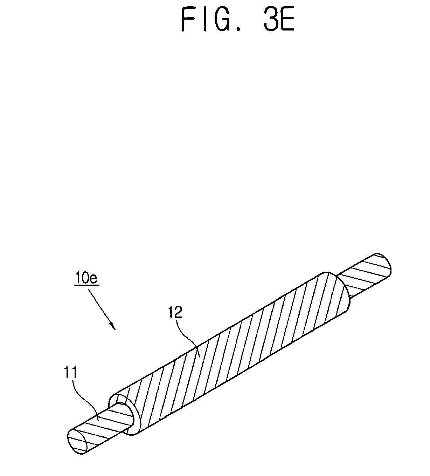

The one-dimensional nano material (10c) embodied in Example 3 shown in FIG. 3C has a double layer structure, in which a tube type core (11) is covered by a shell (12). The core (11) is an organic semiconductor prepared by vapor polymerization or vapor deposition, and the shell (12) is an organic insulator prepared by vapor polymerization.

The one-dimensional nano material (10d) embodied in Example 4 shown in FIG. 3D has a triple layer structure, which is composed of a solid type core (11), the first shell (12) enveloping the core (11) and the second shell (13) enveloping the first shell (12). The core (11) is an organic semiconductor prepared by vapor polymerization or vapor deposition, the first shell (12) is an organic insulator prepared by vapor polymerization, and the second shell (13) is an organic insulator prepared by vapor polymerization.

The one-dimensional nano material (10e) of Example 5 shown in FIG. 3E has a double layer structure, in which a solid type core (11) is covered by a shell (12). The parts of shell (12) covering both ends of the core (11) are cut, thereby exposing the end parts of the core (11). The core (11) is an organic semiconductor prepared by vapor polymerization or vapor deposition, and the shell (12) is an organic insulator prepared by vapor polymerization.

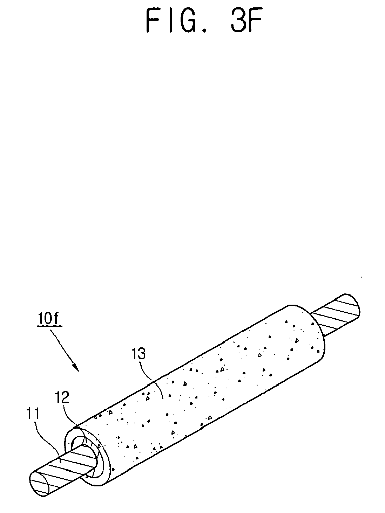

The one-dimensional nano material (10f) embodied in Example 6 shown in FIG. 3F has a triple layer structure, which is composed of a solid type core (11), the first shell (12) enveloping the core (11) and the second shell (13) enveloping the first shell (12). The both ends of the core (11) are exposed outside because the first shell (12) and the second shell (13) thereon are cut off. The core (11) is an organic semiconductor prepared by vapor polymerization or vapor deposition, and the first shell (12) is an organic insulator prepared by vapor polymerization, and the second shell (13) is an organic insulator prepared by vapor polymerization.

Both ends of core (11), an organic semiconductor, of one-dimensional nano materials (10e, 10f) embodied in Example 5 and Example 6 are exposed, by which separate insulator patterning processes for the connection of a source electrode and a drain electrode can be omitted when the present invention is applied to thin film transistors.

One-dimensional nano materials of the present invention are not limited to the above embodiments. For example, one-dimensional nano material having a four layer structure or more could be used and modifications of core and shell components are also possible.

Hereinafter, the preparation method for one-dimensional nano materials of the above examples is described in greater detail.

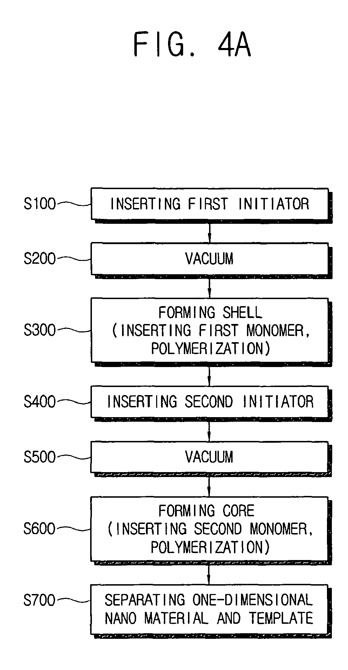

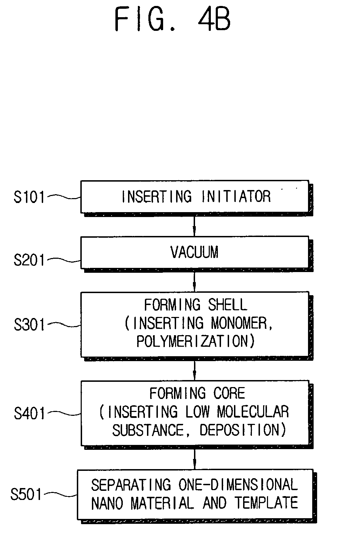

A preparation method for one-dimensional nano materials embodied in Example 2 and Example 3 is described in more detail with reference to FIG. 4A and FIG. 4B. For precise description, a core (11) is limited to an organic semiconductor, and a shell (12) is limited to an organic insulator. FIG. 4A is a flowchart showing the preparation of an organic semiconductor with vapor polymerization to prepare the core (11) of Example 2, and FIG. 4B is a flowchart showing the preparation of an organic semiconductor with vapor deposition to prepare the core (11) of Example 3.

A preparation method for one-dimensional nano material having a high molecular core is described with reference to FIG. 4A.

The first initiator is supplied in a template having numbers of pores under 200 nm in diameter (S100). The first initiator is AIBN (2,2'-azobisisobutyronitrile) or BPO (benzoyl peroxide) triggering radical polymerization, which is supplied by dipping the template in AIBN solution or BPO solution.

Then, the template is placed in a vacuum condition to favor the evaporation of the first monomer (S200).

A shell (12) is formed by supplying and polymerizing the first monomer in a pore (S300). The first monomer can be selected from a group consisting of methylmethacrylate, styrene, divinylbenzene, and vinylphenol, and the selection determines the component of a shell (12), which is formed with one of polymethylmethacrylate, polystyrene, polydivinylbenzene, and polyvinylphenol depending on the first monomer of the pore. The content of the first monomer and polymerization time and conditions have to be properly regulated to prevent the shell (12) from being solid type. Upon completion of forming the shell (12), the remaining first monomer in gas phase is eliminated using vacuum.

Then, the second initiator is inserted in a pore after the shell (12) is formed (S400). The second initiator is preferred to be FeCl₃ triggering redox polymerization. At this time, it is important to supply FeCl₃ under a certain amount to prevent the core (11) from being a conducting polymer.

The template is again placed in vacuum condition to favor the evaporation of the second monomer (S500).

A core (11) is formed in a shell (12) by inserting and polymerizing the second monomer (S600). The second monomer can be selected from a group consisting of pyrrole, aniline, and thiophene, and the selection determines the component of core (11), which may be formed with one of polypyrrole, polyaniline, and polythiophene, in one example.

As a result, one-dimensional nano materials (10b, 10c) are completed in the pores. A solid type core (11) results in one-dimensional nano material (10b) of Example 2. A tube type core (11) results in one-dimensional nano material (10c) of Example 3, and the type of material used is determined by the amount of the second monomer and polymerization time and conditions.

Finally, one-dimensional nano materials (10b, 10c) are separated from the templates (S700). In one example, if a template is anodic aluminum oxide membrane, the template is eliminated by etching with HCl or NaOH to separate one-dimensional nano materials (10b, 10c) from the templates.

A preparation method for one-dimensional nano materials (10b, 10c) having a high molecular core is described in detail in the following experimental example. In the following experimental example, a shell is polymethylmethacrylate and a core is a solid type polypyrrole.

An aluminum membrane template of about 60 µm in thickness having pores 100 nm in diameter is soaked in a AIBN/heptane solution and then taken out to dry. Then, the remaining AIBN on the upper and the lower sides of the template is eliminated by using sandpaper.

The template is transferred to a 100 mL reaction vessel equipped with a sealing apparatus and a monomer injection pipe. The inside of the reaction vessel is depressurized to under 10⁻² torr, to which 0.2 mL of methylmethacrylate monomer is injected, followed by heating at 70□.. The evaporated methylmethacrylate monomer is polymerized to form a polymethylmethacrylate shell.

Then, the template having pores, in which a polymethylmethacrylate shell is formed, is soaked in 0.1 M of FeCl₃ solution and then taken out to dry.

The inside of the reaction vessel is depressurized to under 10⁻² torr, to which 0.4 mL of pyrrole monomer is injected by using a pipette, followed by heating at 70□.. The evaporated pyrrole is polymerized to form a solid type polypyrrole core in the polymethylmethacrylate shell. About 12 hours later, the temperature is lowered and vacuum condition is removed, and the template containing the one dimensional nano material is eliminated by etching in 3M NaOH solution. The salt in the template is dissolved in the solution and the one-dimensional nano material is precipitated. The precipitated one-dimensional nano material is vacuum dried at room temperature to be collected.

A preparation method for one-dimensional nano materials (10b, 10c) having a low molecular core is described with reference to FIG. 4B.

The initiator is inserted in a template having numbers of pores under 200 nm in diameter (S101). The first initiator is AIBN (2,2'-azobisisobutyronitrile) or BPO (benzoyl peroxide) triggering radical polymerization, which is inserted by dipping the template in AIBN solution.

Then, the template is placed in a vacuum condition to favor the evaporation of monomers (S201).

A shell (12) is formed by inserting and polymerizing the monomer in a pore (S301). The monomer can be selected from a group consisting of methylmethacrylate, styrene, divinylbenzene, and vinylphenol, the selection determining the component of a shell (12), which is formed with one of polymethylmethacrylate, polystyrene, polydivinylbenzene, and polyvinylphenol, in one example. The content of the monomer, and polymerization time and conditions have to be properly regulated to prevent the shell (12) from being of the solid type. Upon completion of forming the shell, the remaining first monomer in gas phase is eliminated under vacuum.

Then, a core (11) is formed by depositing a low molecular substance in gas phase in a pore with a shell (12) (S401). The low molecular substance can be either pentacene or rubrene, in one example. As a result, one-dimensional nano materials (10b, 10c) are prepared in the pores. A solid type core (11) results in one-dimensional nano material (10b) of Example 2. A tube type core (11) results in one-dimensional nano material (10c) of Example 3, and the type of the material is determined by the amount of the low molecular substance and polymerization time and conditions.

Finally, one-dimensional nano materials (10b, 10c) are separated from the templates (S501). In one example, if a template is anodic aluminum oxide membrane, the template is eliminated by etching with HCl or NaOH to separate one-dimensional nano materials (10b, 10c) from the templates.

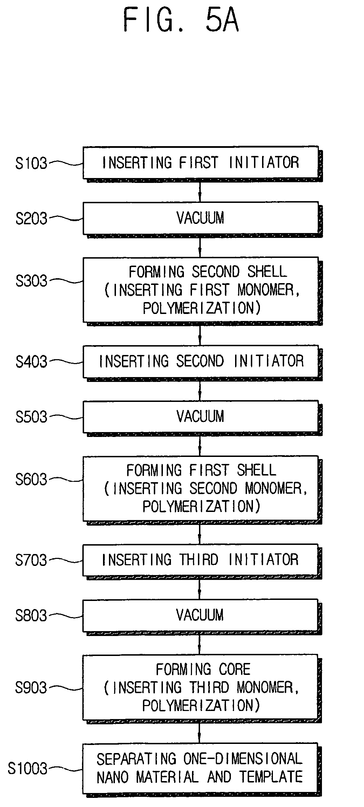

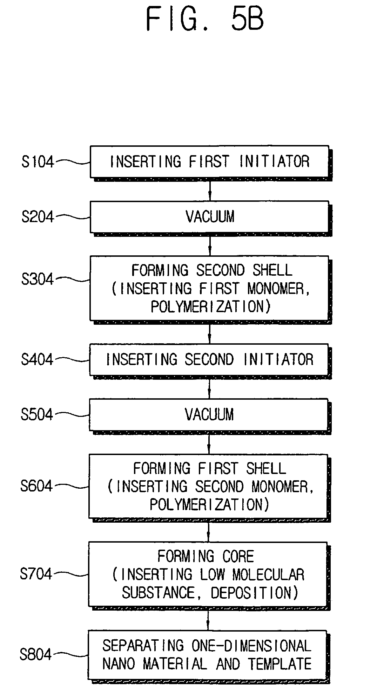

A preparation method for one-dimensional nano material embodied in Example 4 is described with FIG. 5A and FIG. 5B. For the description herein, a core (11) of one-dimensional nano material (10d) is limited to an organic semiconductor, the first shell (12) is limited to an organic semiconductor, and the second shell (13) is limited to a conducting polymer. FIG. 5A is a flowchart showing the preparation of an organic semiconductor with vapor polymerization to prepare the core (11), and FIG. 5B is a flowchart showing the preparation of an organic semiconductor with vapor deposition to prepare the core (11).

A preparation method for one-dimensional nano material (10d) having a high molecular core will now be described with reference to FIG. 5A.

The first initiator is injected in a template having pores under 200 nm in diameter (S103). The first initiator used herein is FeCl₃ triggering redox polymerization. At this time, FeCl₃ is supplied over a certain level to turn the second shell (13) into a conducting polymer.

Then, the template is placed in a vacuum condition to favor the evaporation of the first monomer (S203).

The second shell (13) is formed by supplying and polymerizing the first monomer in a pore (S303). The first monomer can be selected from a group consisting of pyrrole, aniline and thiophene, and the selection determines the type of shell formed. That is, the conductive second shell (13) is formed by either polypyrrole, polyaniline, or polythiophene, in one example, depending on the first monomer. To prevent the second shell (13) from being of a solid type, the amount of the first monomer and polymerization time and conditions have to be properly regulated. Upon completion of forming the second shell (13), the remaining first monomer in gas phase is eliminated using vacuum.

Next, the second initiator is supplied in a pore having the second shell (13) formed therein (S403). The second initiator is AIBN (2,2'-azobisisobutyronitrile) triggering radical polymerization, which is inserted by dipping the template in AIBN solution.

Then, the template is placed in a vacuum condition to favor the evaporation of the second monomer (S503).

The first shell (12) is formed in the second shell (13) by inserting and polymerizing the second monomer (S603). The second monomer can be selected from a group consisting of methylmethacrylate, styrene, divinylbenzene, and vinylphenol, in one example, and the selection determines the component of the first shell (12), which is formed with one of polymethylmethacrylate, polystyrene, polydivinylbenzene, and polyvinylphenol, in one example. The content of the second monomer, polymerization time and conditions have to be properly regulated to prevent the first shell (12) from being of the solid type. Upon completion of forming the first shell (12), the remaining second monomer in gas phase is eliminated under vacuum.

Then, the third initiator is injected in a pore having the first shell (12) (S703) As the third initiator, FeCl₃ triggering redox polymerization is used. At this time, FeCl₃ is supplied under a certain level not to make core (11) as a conducting polymer.

The template is put in a vacuum condition to favor the evaporation of the third monomer (S803).

Then, a core (11) is formed in the first shell (12) by supplying and polymerizing the third monomer (S903). The third monomer can be selected from a group consisting of pyrrole, aniline, and thiophene, in one example, and the selection determines the component of the core (11), which is formed with one of polypyrrole, polyaniline, and polythiophene, in one example. As a result, one-dimensional nano material (10d) is prepared in a pore.

Finally, the one-dimensional nano material (10d) is separated from the template (S1003). In one example, if a template is anodic aluminum oxide membrane, the template is eliminated by etching with HCl or NaOH to separate the one-dimensional nano material (10d) from the template.

A preparation method for one-dimensional nano material (10d) having a low molecular core is described with reference to FIG. 5B.

The forming processes (S104 - S604) of the second shell (13) and the first shell (12) are substantially the same as described above with respect to FIG. 5A.

After forming the first shell (12), a low molecular substance in gas phase is supplied in a pore wherein the first shell (12) is formed, and deposited, to form a core (11) (S704). The low molecular substance is either pentacene or rubrene, in one example. As a result, one-dimensional nano material (10d) is prepared in a pore.

Finally, the one-dimensional nano material (10d) is separated from the template (S804). In one example, if a template is anodic aluminum oxide membrane, the template is eliminated by etching with HCl or NaOH to separate the one-dimensional nano material (10d) from the template.

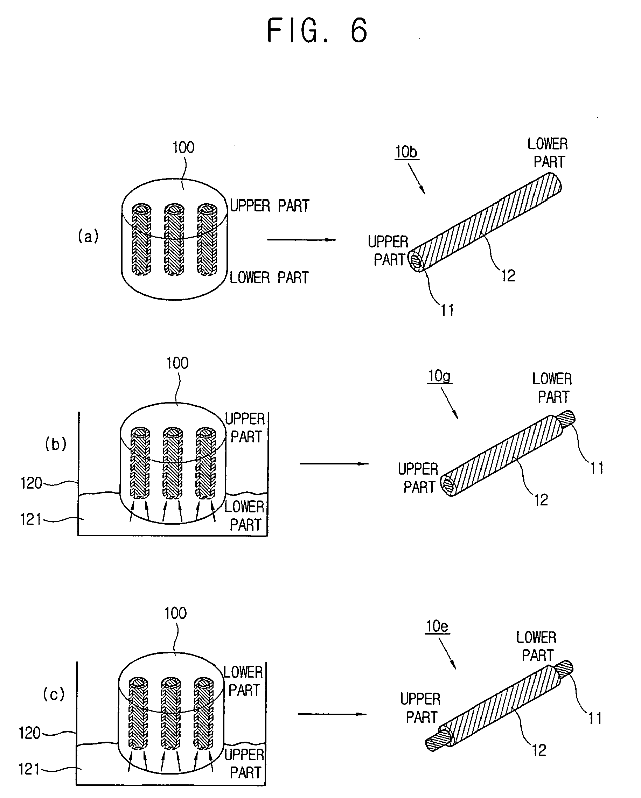

FIG. 6 is a schematic diagram showing the preparation method for one-dimensional nano material of Example 5 of the present invention. For the description, core (11) of one-dimensional nano material (10e) is limited to an organic semiconductor, and a shell (12) is limited to a high molecular insulator.

At first, as shown in (a), one-dimensional nano material (10b) of Example 2 is prepared in a pore (11) of a template (100). The preparation method for the one-dimensional nano material (10b) is substantially the same as described above with respect to FIG. 4A and FIG. 4B.

Next, as shown in (b), upon completion of producing one-dimensional nano material (10b) in a template (100), one side of the template (100) is dipped in a bath (120) containing a solvent (121) dissolving a high molecular insulator forming a shell (12) selectively. The solvent (121) is either acetone or methylenechloride in one example.

After dipping, the solvent (121) rises by capillary phenomenon to selectively dissolve the shell (12) of one-dimensional nano material (10b), resulting in another one-dimensional nano material (10g) having a part of core (11) exposed.

Then, as shown in (c), after inserting the produced one-dimensional nano material (10g) in a template (100), the other part of the template is dipped in a bath (120) containing the solvent (121). After dipping, the solvent (121) rises by capillary phenomenon to selectively dissolve the shell (12) of one-dimensional nano material (10g). As a result, the one-dimensional nano material (10e) with both sides of core (11) exposed is produced.

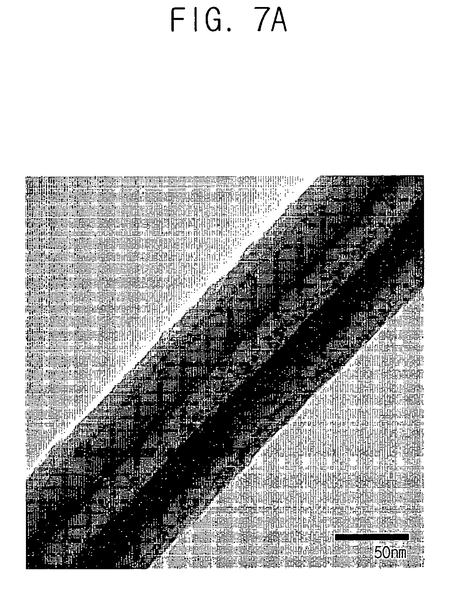

FIG. 7A through FIG. 7C are transmission electron microscope (TEM) photographs of one-dimensional nano materials prepared by the method of the present invention.

FIG. 7A is a TEM photograph showing one-dimensional nano material having a double layer structure which is composed of a tube type core and a shell enveloping the core.

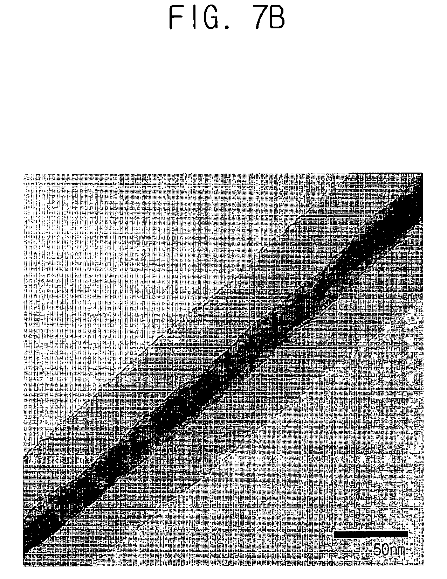

FIG. 7B is a TEM photograph showing one-dimensional nano material having a double layer structure which is composed of a solid type core and a shell enveloping the core.

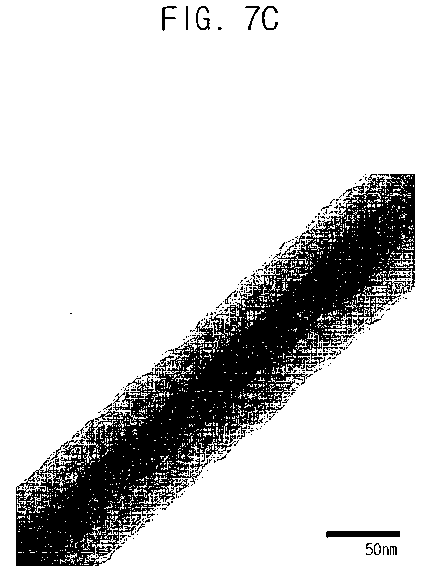

FIG. 7C is a TEM photograph showing one-dimensional nano material having a triple layer structure which is composed of a solid type core and a pair of shells covering the core.

The prepared one-dimensional nano material is approximately 100 nm round, in which borders between a core and a shell and between shells are smooth and even.

The one-dimensional nano material of the present invention is applicable to display devices such as LCD, OLED, etc. Particularly, the one-dimensional nano material of the invention can be used to form a thin film transistor, a switching element of a display device.

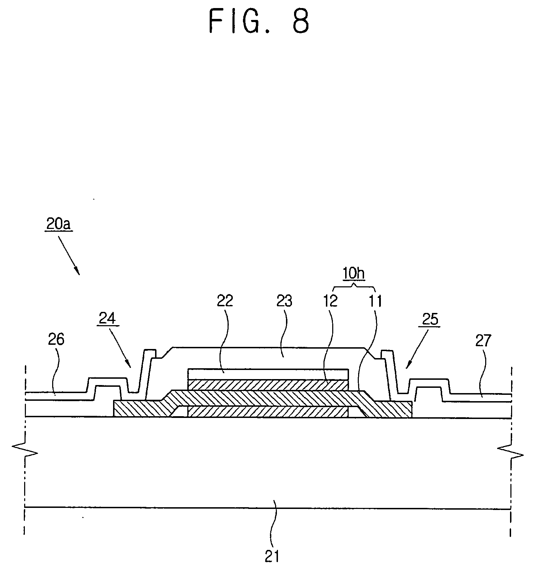

FIG. 8 through FIG. 10 are sectional drawings of thin film transistor substrates of Examples 7 through 9 of the present invention.

FIG. 8 presents the thin film transistor substrate (20a) of Example 7, in which one-dimensional nano material (10h) is positioned on the insulated substrate (21).

The insulated substrate (21) may be made of plastic in one example. When made of plastic, the thin film transistor substrate (20a) has flexibility. Plastic used herein is exemplified by polycarbon, polyimide, PES, PAR, PEN, and PET, etc.

One-dimensional nano material (10h) is composed of a core (11) formed of an organic semiconductor, and a shell (12) formed of an organic insulator and covering the core (11). The shell (12) is eliminated in the area of both ends of the one-dimensional nano material (10h), resulting in the exposure of the core (11).

The one-dimensional nano material (10h) with cores of both ends exposed is prepared by substantially the same method as described above with respect to FIG. 6. Otherwise, the one-dimensional nano material (10b) of Example 2 is loaded on the insulated substrate (21), followed by photolithography to produce the above material (10h).

On an upper part of shell (12), a gate electrode (22) is formed. A shell (12) made of organic insulator disposed between gate electrode (22) and the core (11) separates the two. Gate electrode (22) is composed of either Al or Au in one example.

An insulator film (23) is formed on top of gate electrode (220 and on the core (11) not covered by a shell (12). Insulator film (23) can be produced by an inorganic substance such as silicon nitride or silicon oxide or an organic substance such as BCB. Insulator film (23) has contact holes (24, 25) for contacting core (11) at both ends.

On top of insulator film (23), a source electrode (26) and a drain electrode (27) are formed. Gate electrode (22) is disposed between source electrode (26) and drain electrode (27), which are connected to one end and the other end of core (11), respectively, through contact holes (24, 25).

One-dimensional nano material (10h) included in the thin film transistor substrate (20a) of Example 7 is composed of an organic semiconductor and an insulating layer between the organic semiconductor and gate electrode. It may make the production line simple, and further thermal processing for insulating substrate (21) can be reduced if a plastic insulating substrate (21) is used.

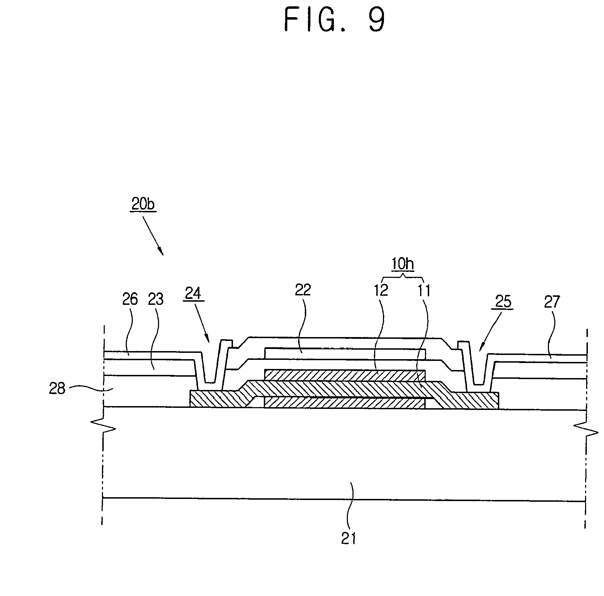

The differences between thin film transistor substrate (20b) of Example 8 represented in FIG. 9 and thin film transistor substrate (20a) of Example 7 are described.

Inter-layered insulator film (28) is additionally formed between one-dimensional nano material (10h) and gate electrode (22). Gate electrode (22) may be formed by photolithography after full-deposition of gate metal on the inter-layered insulator film (28).

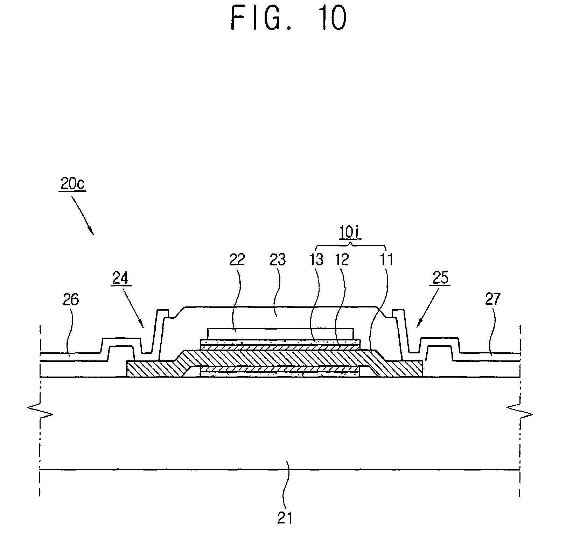

As shown in FIG. 10, the differences between thin film transistor substrate (20b) of Example 9 and thin film transistor substrate (20a) of Example 7 are described as follows.

One-dimensional nano material (10i) is composed of a core (11) formed by an organic semiconductor, the first shell (12) formed by an organic insulator, and the second shell (13) formed by a conducting polymer and enveloping the first shell (12). The first shell (12) and the second shell (13) at both ends of the one-dimensional nano material (10i) are eliminated, resulting in the exposure of the core (11) in those regions.

The one-dimensional nano material (10i) can be prepared by loading one-dimensional nano material (10d) of Example 4 on an insulating substrate (21), followed by photolithography.

The one-dimensional nano material (10i) can also be prepared by substantially the same method as described above with respect to Example 6. At this time, a solvent (121) has to be the one that is able to dissolve the first shell (12) and the second shell (13) at the same time. Different solvents (121) each dissolving the first shell (12) and the second shell (13) separately may be used and in that case, dipping is conducted for each solvent (121).

Gate electrode (22) contacts the second shell (13) composed of a conducting polymer.

Advantageously, the thin film transistor substrate of the present invention can be applied to the production of an LCD or an organic light emitting diode, etc. The one-dimensional nano material of the present invention reduces the line width and makes low-voltage drive possible. In addition, pixel size is also decreased. In the one-dimensional nano material of the preset invention, it is not difficult to regulate thickness of a core and a shell and is easy to change band gap energy of an organic semiconductor and leakage current level of an organic insulator.

An organic light emitting diode is an auto-luminescent device having an organic substance that emits after receiving an electric signal. In the organic light emitting diode, an anode layer (pixel electrode), a hole injection layer, a hole transfer layer, an emitting layer, an electron transfer layer, an electron injection layer, and a cathode layer (counter electrode) are laminated. A drain electrode of the thin film transistor substrate according to the present invention is electrically connected to the anode for recognizing data signals.

As explained hereinbefore, the present invention provides a preparation method for one-dimensional nano materials facilitating the regulation of wall thickness and the formation of multiple layers in the materials.

The present invention also provides one-dimensional nano materials produced by the method of the invention facilitating the regulation of wall thickness and the formation of multiple layers.

The present invention further provides a thin film transistor substrate prepared by using the one-dimensional nano material prepared by the method of the invention facilitating the regulation of wall thickness and the formation of multiple layers.

Although a few exemplary embodiments of the present invention have been shown and described, it will be appreciated by those skilled in the art that changes may be made in these embodiments without departing from the principles and spirit of the invention, the scope of which is defined in the appended claims and their equivalents.

## Claims

1. A method for preparing a display device, the method comprising:
providing a template having at least one pore; and
generating a one-dimensional nano material in the pore by supplying an organic substance in gas phase.

2. The method as set forth in claim 1, wherein the organic substance is supplied under a vacuum condition.

3. The method as set forth in claim 1, wherein the organic substance is supplied by evaporating the organic substance in liquid phase.

4. The method as set forth in claim 1, further comprising supplying an additional organic substance which is different from the organic substance.

5. The method as set forth in claim 1, wherein the organic substance is selected from the group consisting of methylmethacrylate, styrene, divinylbenzene, vinylpropylene, pyrrole, aniline, thiophene, pentacene, rubrene, and mixtures thereof.

6. The method as set forth in claim 1, wherein the organic substance is a low molecular substance, and the one-dimensional nano material is an assembly of the low molecular substance.

7. The method as set forth in claim 6, wherein the organic substance comprises one of pentacene and rubrene.

8. The method as set forth in claim 1, wherein the organic substance is a monomer, and further comprising polymerizing the monomer in the pore.

9. The method as set forth in claim 8, wherein the polymerizing is performed at between about 50□ and about 200□..

10. The method as set forth in claim 8, further comprising supplying an initiator in the pore before the injection of the organic substance.

11. The method as set forth in claim 10, wherein the initiator is a radical polymerization initiator.

12. The method as set forth in claim 11, wherein the organic substance is selected from the group consisting of methylmethacrylate, styrene, divinylbenzene, vinylphenol, and mixtures thereof.

13. The method as set forth in claim 11, wherein the initiator comprises at least one of 2,2'-azobisisobutyronitrile (AIBN) and benzoyl peroxide (BPO).

14. The method as set forth in claim 10, wherein the initiator is an oxidizing agent.

15. The method as set forth in claim 13, wherein the organic substance is selected from the group consisting of pyrrole, aniline, thiophene, and mixtures thereof.

16. The method as set forth in claim 13, wherein the initiator comprises FeCl₃.

17. The method as set forth in claim 1, wherein the template is composed of anodic aluminum oxide membrane.

18. The method as set forth in claim 1, further comprising separating the one-dimensional nano material from the template.

19. The method as set forth in claim 18, wherein the template is composed of an anodic aluminum oxide membrane, and further wherein the one-dimensional nano material is separated from the template by etching.

20. The method as set forth in claim 19, wherein at least one of sodium hydroxide and chloric acid is used for etching of the template.

21. The method as set forth in claim 1, wherein the one-dimensional nano material generated in the pore is composed of a core and a tube type shell covering the core, and further comprising removing both ends of the shell.

22. The method as set forth in claim 21, wherein the core is an organic semiconductor and the shell is an organic insulator.

23. The method as set forth in claim 21, wherein the removing is performed by supplying a solvent that selectively dissolves the shell at both ends.

24. The method as set forth in claim 22, wherein the solvent comprises at least one of acetone and methylenechloride.

25. A method for preparing a display device, the method comprising:
providing a template having at least one pore under about 200 nm in diameter;
supplying an initiator in the pore;
generating a one-dimensional nano material in the pore by supplying and polymerizing a monomer in gas phase; and
separating the generated one-dimensional nano material from the template.

26. The method as set forth in claim 25, wherein the monomer is supplied by evaporating the monomer in liquid phase.

27. A display device, comprising:
a tube type shell under about 200 nm in diameter; and
a core formed in the shell.

28. The display device as set forth in claim 27, wherein at least one of the shell and the core is a conducting polymer.

29. The display device as set forth in claim 28, wherein the conducting polymer is selected from the group consisting of polypyrrole, polyaniline, and polythiophene.

30. The display device as set forth in claim 27, wherein at least one of the shell and the core is an organic semiconductor.

31. The display device as set forth in claim 30, wherein the organic semiconductor is selected from the group consisting of polypyrrole, polyaniline, polythiophene, pentacene, and rubrene.

32. The display device as set forth in claim 27, wherein one of the shell and the core is an organic insulator.

33. The display device as set forth in claim 29, wherein the organic insulator is selected from the group consisting of polymethylmethacrylate, polystyrene, polydivinylbenzene, and polyvinylphenol.

34. The display device as set forth in claim 27, wherein the shell is an organic insulator and the core is an organic semiconductor.

35. The display device as set forth in claim 34, wherein the shell is eliminated at both ends to expose the core.

36. The display device as set forth in claim 34, wherein the core is a solid type.

37. The display device as set forth in claim 27, further comprising an additional shell formed between the core and the shell.

38. The display device as set forth in claim 37, wherein the core is an organic semiconductor, the shell is an organic insulator, and the additional shell is a conducting polymer.

39. The display device as set forth in claim 37, wherein the core is a solid type.

40. A display device, comprising:
an organic semiconductor core;
an organic insulator shell covering the organic semiconductor core; and
a conducting polymer shell under about 200 nm in diameter covering the organic insulator shell.

41. The display device as set forth in claim 40, wherein the organic semiconductor core is selected from the group consisting of polypyrrole, polyaniline, polythiophene, pentacene, and rubrene.

42. The display device as set forth in claim 40, wherein the organic insulator shell is comprised of material selected from the group consisting of polymethylmethacrylate, polystyrene, polydivinylbenzene, and polyvinylphenol.

43. The display device as set forth in claim 40, wherein the conducting polymer shell is comprised of material selected from the group consisting of polypyrrole, polyaniline, and polythiophene.

44. A thin film transistor substrate, comprising:
a one dimensional nano material comprising a tube type shell made of organic insulator and a core made of organic semiconductor formed in the shell, wherein the one-dimensional nano material is under about 200 nm in diameter and the core is exposed at both ends;
a gate electrode over the core covered by the shell;
a source electrode connected to one end of the core; and
a drain electrode connected to the other end of the core.

45. The thin film transistor substrate as set forth in claim 44, wherein the gate electrode contacts the shell.

46. The thin film transistor substrate as set forth in claim 44, wherein the core is a solid type.

47. The thin film transistor substrate as set forth in claim 44, wherein the one-dimensional nano material further comprises an additional shell composed of a conducting polymer which is a tube type to accommodate the shell.

48. The thin film transistor substrate as set forth in claim 47, wherein the gate electrode contacts the additional shell.

49. The thin film transistor substrate as set forth in claim 47, wherein the additional shell is comprised of a material selected from the group consisting of polypyrrole, polyaniline, and polythiophene.

50. The thin film transistor substrate as set forth in claim 44, wherein the core is comprised of a material selected from the group consisting of polypyrrole, polyaniline, polythiophene, pentacene, and rubrene.

51. The thin film transistor substrate as set forth in claim 44, wherein the shell is comprised of material selected from the group consisting of polymethylmethacrylate, polystyrene, polydivinylbenzene, and polyvinylphenol.
